Europäisches Patentamt

European Patent Office

Office européen des brevets

(11) Publication number: **0 463 373 A2**

## EUROPEAN PATENT APPLICATION

(21) Application number: **91108472.1**

(22) Date of filing: **24.05.91**

(51) Int. Cl.5: **H01L 21/90, H01L 23/532**

(30) Priority: **29.06.90 US 546193**

(43) Date of publication of application:
**02.01.92 Bulletin 92/01**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Gunturi, Sarma S.**
**1403 Stoneboro**
**Richardson, Texas 75082(US)**
Inventor: **Kleinert, Christian**
**2512 Belmont Place**
**Plano, Texas 75023(US)**

(74) Representative: **Leiser, Gottfried, Dipl.-Ing. et al**
**Patentanwälte Prinz, Leiser, Bunke & Partner**
**Manzingerweg 7**
**W-8000 München 60(DE)**

(54) **Local interconnect using a material comprising tungsten.**

(57) A tungsten silicide interconnect (28) is formed on device (10) as a local interconnect between devices. The tungsten silicide interconnect (28) provides several advantages over prior art methods, such as titanium nitride or polysilicon local interconnects.

*FIG. 1a*
(PRIOR ART)

*FIG. 1b*
(PRIOR ART)

## TECHNICAL FIELD OF THE DISCLOSURE

This invention relates in general to integrated circuits, and more particularly to a local interconnect using tungsten.

## BACKGROUND OF THE DISCLOSURE

As MOS technology is scaled to the sub-micron regime, the use of traditional buried contact process to increase packing density becomes less attractive, since the dopant outdiffusion from the polysilicon reduces isolation integrity and adversely affects active device characteristics. These problems limit buried contact design rule scaling, which consequently restricts packing density improvements. In CMOS, phosphorus doped polysilicon is often used for both the N and P-channel gates; this restricts the use of buried contacts to N-channel devices.

One proposed solution is to use a TiN layer to form local interconnects. The TiN layer may be formed during the self-aligned $TiSi_2$ process wherein polysilicon and silicon surfaces exposed to titanium form $TiSi_2$ and the titanium layer covering oxide surfaces forms TiN (because of the nitrogen ambient). The TiN formed during the silicidation process may be etched to form local interconnects. The proposed solution is discussed in Thomas Tang et al., "VLSI Local Interconnect Level Using Titanium Nitride," IEDM 1985, pp. 590-593.

The TiN local interconnect process has a major drawback which renders it unsuitable for many applications. The etchants used to form the local interconnects from the TiN layer do not have a sufficient selectivity towards $TiSi_2$, silicon or polysilicon. Hence, forming the TiN local interconnect layer may result in significant damage to the integrated circuit.

Another proposed solution is to form a polysilicon local interconnect which contacts the gates and/or diffused regions of the integrated circuit. However, such a process would only be suitable for NMOS and cannot be used with CMOS, thereby significantly restricting its applicability.

Therefore, a need has arisen in the industry for a local interconnect structure which does not damage other portions of the integrated circuit.

## SUMMARY OF THE DISCLOSURE

In accordance with the present invention, a local interconnect is provided which substantially eliminates problems associated with prior local interconnects.

In the present invention, a local interconnect structure is created by defining a local interconnect structure and forming interconnects in accordance therewith using a material including tungsten.

This aspect of the present invention provides an interconnect structure which can be formed using an etch which is selective to the underlying silicon, polysilicon portions of the integrated circuit. For example, if a tungsten silicide layer is used to form the interconnects, the layer may be etched using a fluorine and Freon-114 based etchant. Further, a tungsten silicide material has a low resistivity and is compatible with subsequent high-temperature processes.

## BRIEF DESCRIPTION OF THE DRAWINGS

For a more complete understanding of the present invention, and the advantages thereof, reference is now made to the following descriptions taken in conjunction with the accompanying drawings, in which:

FIGUREs 1a-b illustrate cross-sectional and top-plan views of a prior art local interconnect structure;

FIGURE 2 illustrates a cross-sectional view of an integrated circuit according to the present invention after a first processing stage; and

FIGURE 3 illustrates a cross-sectional side view of the integrated circuit according to the present invention after second processing stage.

## DETAILED DESCRIPTION OF THE DISCLOSURE

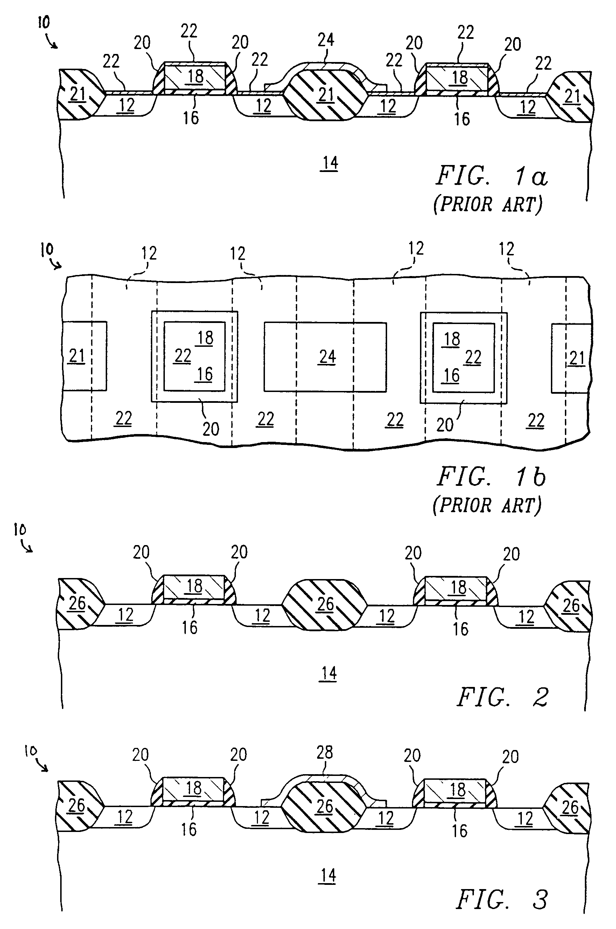

The preferred embodiment of the present invention is best understood by referring to FIGUREs 1-3 of the drawings, like numerals being used for like and corresponding parts of the various drawings.

FIGUREs 1a-b illustrate a cross-sectional side view and a top-plan view, respectively, of a prior art local interconnect structure used in conjunction with an MOS integrated circuit. For illustrative purposes, the local interconnect structure is shown connecting the diffused regions of two MOS transistors.

In FIGUREs 1a-b, a portion of an integrated circuit 10 is shown wherein diffused regions 12 are formed in a semiconductor substrate 14. Diffused regions 12 may be either N or P type depending upon the particular transistors being formed. Gate oxide 16 is formed over the surface of the substrate 14. Gates 18 are formed over the gate oxide layer 16, typically by forming a polysilicon layer over the device and patterning and etching the polysilicon layer. Sidewall oxide regions 20 are formed by depositing a thick layer of oxide over the gates 18 and anisotropically etching the oxide layer. Field oxide regions 21 are formed using thermal oxidation techniques. A self-aligned titanium silicide ($TiSi_2$) process is used to reduce gate N-junction sheet resistances to less than 1 ohm per square. A layer of titanium is disposed over the surface of the device, and a reaction between the titanium and silicon is performed in a nitrogen ambient at approximately 675°C. This reaction creates a titanium silicide layer 22 over the silicon and polysilicon portions of the device 10. The unreacted portions of the titanium layer on top of the oxide and over the titanium silicide layer 22 becomes TiN.

To form the TiN local interconnect 24, the device is patterned with photoresist after the titanium reaction step, and the resist is hardened using a high temperature bake and deep UV exposure. The TiN layer is then etched using a dry/wet etch comprising a fluorine-based dry etch and a $NH_4OH + H_2O_2 + H_2O$ wet etch.

Unfortunately, the procedure for etching the TiN to form the interconnects is not particularly selective to the silicon, polysilicon and titanium silicide portions of the device 10. Hence, in forming the interconnects, it is very possible that the device will be damaged. Further, the titanium silicide layer 22 is subject to peeling after the wet etch used to form the interconnect structure.

FIGUREs 2 and 3 illustrate cross-sectional side views of the present invention after first and second processing stages, respectively. While the invention is shown using the MOS interconnect structure of FIGUREs 1a-b, it may be used with any integrated circuit architecture, such as bipolar, etc.

In FIGURE 2, the gates 18, diffused regions 12, sidewall oxides 20, gate oxide 16 and field oxide regions 21 are formed as discussed in connection with FIGUREs 1a-b. Optionally, the diffused regions 12 and gates 18 may be silicided, thereby forming $TiSi_2$ layers 22 (not shown). After silicidation, if any, the TiN by-product is stripped.

In FIGURE 3, a thin layer of tungsten silicide ($WSi_x$) is deposited over the polysilicon gate layer after the sidewall oxide process has been completed. Typically, the deposited $WSi_x$ layer comprises a ratio of 2.5:1 (W:Si). During subsequent processing, however, the ratio may vary dependent upon the high temperature cycles employed.

The deposited tungsten silicide layer is patterned and etched using a fluorine-based chemistry to form the local interconnect 28. The thickness of the tungsten silicide will depend upon the application and the desired resistance. Experimentally, a thickness of 3200 Angstroms has been used. The tungsten silicide layer may be etched using a well-established fluorine-based dry etch process. For example, $SF_6$ and Freon-114 may be used to etch the tungsten silicide layer to form the interconnect.

The tungsten silicide interconnect provides several advantages over the prior art. The fluorine-based dry etch process is highly selective to silicon, polysilicon and titanium silicide, and therefore will not damage the device during formation of the local interconnect. Further, tungsten silicide has a resistance of approximately 2-10 ohms per square, which compares favorably with titanium nitride and polysilicon. Further, the resistivity of the interconnect can be varied during processing by controlling the tungsten/silicon ratio.

It should be noted, that whereas the tungsten silicide local interconnect 28 has been shown connecting two diffused regions, it could be used in any situation where a local interconnect is desired.

Although the present invention has been described in detail, it should be understood that various changes, substitutions and alterations can be made herein without departing from the spirit and scope of the invention as defined by the appended claims.

## Claims

1. A method of forming a local interconnect structure on an integrated circuit structure, comprising the steps of:
   defining a local interconnect structure between two normally isolated areas of the integrated circuit; and
   forming the local interconnect structure using a material comprising tungsten.

2. The method of Claim 1 wherein said forming step comprises the steps of:
   forming a layer comprising tungsten on the surface of the integrated circuit structure; and
   removing portions of the layer to form the local interconnect structure on the integrated circuit structure.

3. The method of Claim 2 wherein said layer forming step comprises the step of depositing a layer comprising tungsten on the integrated circuit structure.

4. The method of Claim 3 wherein said depositing step comprises the step of depositing a tungsten and silicon compound.

5. The method of Claim 2 wherein said removing step comprises the step of etching the layer with an fluorine based etchant.

6. The method of Claim 5 wherein said removing step comprises the step of etching the layer with an etchant comprising $SF_6$.

7. The method of Claim 6 wherein said etching step comprises the step of etching the layer with and etchant comprising $SF_6$ and Freon-

114.

8. The method of Claim 1 and further comprising the step of subjecting the material comprising tungsten to one or more high temperature cycles.

9. A method of forming an integrated circuit comprising the steps of:

forming gate and diffused regions on a semiconductor surface; and

forming a tungsten silicide layer on the gate and diffused regions;

removing portions of the tungsten silicide layer to form interconnects between selected gates and diffused regions.

10. The method of Claim 9 wherein said gate regions comprise polysilicon.

11. The method of Claim 9 wherein said step of forming a tungsten silicide layer comprises the step of depositing a tungsten silicide layer.

12. The method of Claim 9 wherein said removing step comprises the step of etching the tungsten silicide layer using a fluorine based dry etch process.

13. The method of Claim 9 and further comprising the step of forming sidewall oxide regions adjacent said gate regions.

14. The method of Claim 9 and further comprising the step of forming a titanium silicide layer over one or more of the diffused regions.

15. An integrated circuit comprising:

a plurality of electrically isolated regions; and

a local interconnect structure comprising tungsten for coupling ones of the isolated regions.

16. The integrated circuit of Claim 15 wherein said local interconnect structure comprises a titanium silicide structure.

17. The integrated circuit of Claim 15 wherein said electrically isolated regions comprise gate regions and diffused regions.

10

22    22    20    24    22    22    20    22
20    22    20    22              22    20    22

21    18    21    18    21    18    21
12    16    12    16    12    16    12    16    12

14

*FIG. 1a*
*(PRIOR ART)*

10

12          12                    12          12

18          18
22    16    24    22    16
21          20          24          20          21

22    22    22    20    22    22

*FIG. 1b*
*(PRIOR ART)*

10

20    20    20    20
18    18
26    12    26    12    26    12    26
16    16

14

*FIG. 2*

10

20    20    28    20    20
18    18
26    12    26    12    26    12    26
16    16

14

*FIG. 3*